# FASCICULE DE BREVET EUROPEEN

(11) **EP 0 801 312 B1**
(45) Date de publication et mention de la délivrance du brevet: **19.05.2004**
(21) Numéro de dépôt: 97400695.9
(22) Date de dépôt: 27.03.1997
(51) Int. Cl.: G01R 31/327

(54) **Procédé de surveillance de l'usure électrique des sectionneurs d'aiguillage d'un poste haute tension**
Verfahren zur Überwachung des Verschleisses von Trennschaltern einer Hochspannungsanlage
Procedure for monitoring the electrical wear of section switches in a high voltage station

(30) Priorité: 12.04.1996 FR 9604602
(43) Date de publication de la demande: 15.10.1997
(73) Titulaire: Alstom T & D SA, 75116 Paris (FR)
(72) Inventeur: Marmonier, Jean, 73100 Aix Les Bains (FR)
(74) Mandataire: Audier, Philippe André

(56) Documents cités:
- EP-A- 0 574 300
- EP-A- 0 665 567
- DE-A- 3 642 108

## Description

L'invention concerne un procédé de surveillance de l'usure électrique des sectionneurs d'aiguillage d'un poste haute tension.

Elle se rapporte plus précisément à un procédé de surveillance de l'usure électrique des sectionneurs d'aiguillage d'une travée d'un poste haute tension comportant un jeu de barres de distribution relié à au moins trois circuits électriques constitués de travées d'entrée et de sortie et d'une travée de couplage des barres, chaque travée comportant une ligne de connexion à chaque barre équipée d'un sectionneur d'aiguillage et étant associée à un calculateur de travée pouvant déterminer la valeur et la polarité du courant passant dans la travée, ainsi que l'état des sectionneurs d'aiguillage de la travée, tous les calculateurs du poste étant reliés par une ligne de transfert d'informations.

Dans un tel poste connu, une fonction des sectionneurs d'aiguillage et de la travée de bouclage est de permettre le transfert en charge d'une barre à une autre, c'est-à-dire sans interruption de la distribution. Lors d'un tel transfert en charge, un sectionneur d'aiguillage doit s'ouvrir alors qu'un courant non négligeable le traverse. Or un sectionneur subit lors de cette manoeuvre une usure électrique qu'il importe de surveiller.

Il est connu de surveiller l'usure mécanique de tels sectionneurs en comptabilisant simplement le nombre de manoeuvres de chaque sectionneur. Cependant, une telle surveillance est insuffisante lorsque les opérations de transfert en charge sont nombreuses et que la limite admissible d'usure électrique s'avère être atteinte avant que le nombre maximal admissible de manoeuvres le soit.

Par ailleurs, un tel poste connu est équipé de calculateurs de travée qui transmettent des informations d'états à un poste de contrôle opérateur, telles que la positions des sectionneure et du disjoncteur que comporte également les travées d'entrée et de sortie et la valeur du courant de chaque travée afin d'assurer la protection de ce disjoncteur.

Par ailleurs, les documents de brevets EP 0 574 300 et EP 0 665 567 décrivent des systèmes de surveillance de disjoncteur.

La présente invention consiste en un procédé de surveillance de l'usure électrique des sectionneurs d'aiguillage, jusqu'ici non surveillée, qui ne nécessite aucun matériel supplémentaire spécifique.

Pour ce faire, le procédé conforme à l'invention consiste au traitement suivant:
- lors d'un transfert en charge de la travée, lorsque le calculateur de travée correspondant détecte que les sectionneurs des lignes de connexion aux barres de distribution sont fermés, ce dernier envoie un message aux autres calculateurs qui déterminent et enregistrent les données que sont la valeur et la polarité du courant de leur travée,
- lorsque le calculateur de la travée a détecté l'ouverture du sectionneur d'aiguillage de la ligne de connexion à la barre dont la distribution est transférée dite barre transférée, lesdites données antérieures à l'ouverture sont mémorisées et la valeur du carré du courant coupé par ledit sectionneur est calculée, cette valeur étant représentative de l'usure électrique dudit sectionneur.

Selon un mode de réalisation préféré,
- ledit calculateur envoie ledit message aux autres calculateurs via un calculateur de niveau supérieur,
- lesdites données sont transmises au calculateur de niveau supérieur qui en déduit par calcul la valeur du carré du courant coupé par ledit sectionneur.

De préférence, le calculateur de niveau supérieur transmet la valeur du carré du courant coupé au calculateur de la travée qui effectue la sommation des valeurs au fur et à mesure des différents transferts en charge et compare cette somme à une valeur limite admissible.

Le calcul du courant coupé par ledit sectionneur s'effectue en ajoutant les valeurs de courant entrant sur la barre transférée et en retranchant les valeurs de courant sortant de la barre transférée.

L'invention permet une détermination précise de la valeur du courant coupé par le sectionneur.

L'invention est décrite plus en détail à l'aide de figures ne représentant qu'un mode de réalisation préféré de l'invention.

Les figures 1A à 1C sont des vues schématiques d'un poste haute tension et illustrent le principe d'un transfert en charge.

Les figures 2A à 2D représentent un poste haute tension avec ces équipements de contrôle et illustrent le procédé conforme à l'invention.

Les différentes figures représentent un poste haute tension comportant
- deux barres de distribution B1, B2,
- une travée d'entrée T3 équipée d'un disjoncteur D3 et comportant une ligne de connexion à la première travée B1 équipée d'un sectionneur S31 d'aiguillage et une ligne de connexion à la seconde travée B2 équipée d'un sectionneur S32 d'aiguillage,
- deux travées de sortie T1, T2 équipée chacune d'un disjoncteur D1, D2 et comportant chacune une ligne de connexion à la première travée B1 équipée d'un sectionneur S11, S21 d'aiguillage et une ligne de connexion à la seconde travée B2 équipée d'un sectionneur S12, S22 d'aiguillage,
- une travée de couplage T4 des deux barres B1, B2 équipée de deux sectionneurs S41, S42.

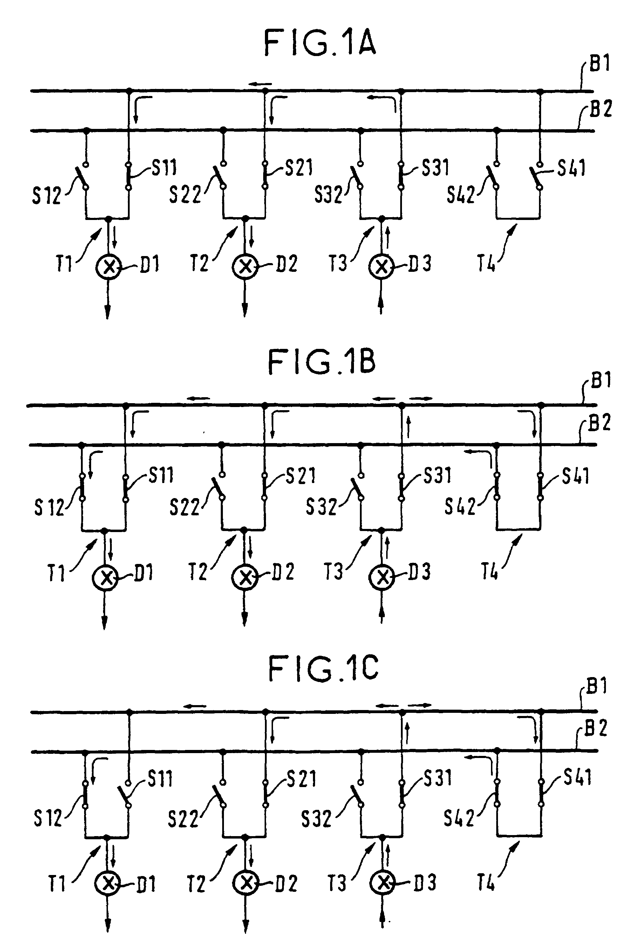

Sur les figures 1A à 1C, les flèches représentent les courants.

La figure 1A illustre le poste avant une opération de transfert en charge. La travée de couplage est alors inopérante, ses sectionneurs S41 et S42 sont ouverts. Le courant entre par la travée d'entrée T3 et est distribué par la première barre B1 aux travées de sortie T1 et T2. Tous les sectionneurs d'aiguillage des lignes de connexion à la première barre B1 sont donc fermés et tous les sectionneurs d'aiguillage des lignes de connexion à la seconde barre B2 sont donc ouverts.

Selon la figure 1B, une opération de transfert en charge de la travée T1 a lieu. Les sectionneurs S41 et S42 de la travée de bouclage sont tout d'abord fermés et le sectionneur d'aiguillage S12 de la ligne de connexion à la seconde barre B2 de la travée T1 est ensuite fermé. Le courant circule alors selon les flèches représentés et la travée T1 reçoit du courant de la première barre B1 et de la seconde barre B2.

Puis le sectionneur d'aiguillage S11 de la ligne de connexion à la première barre B1 est ouvert comme représenté sur la figure 1C. La travée T1 ne reçoit le courant que de la seconde barre B2, la distribution étant transférée de la première barre B1 à la seconde barre B2 pour la travée T1. L'opération de transfert en charge de la travée T1 est terminée.

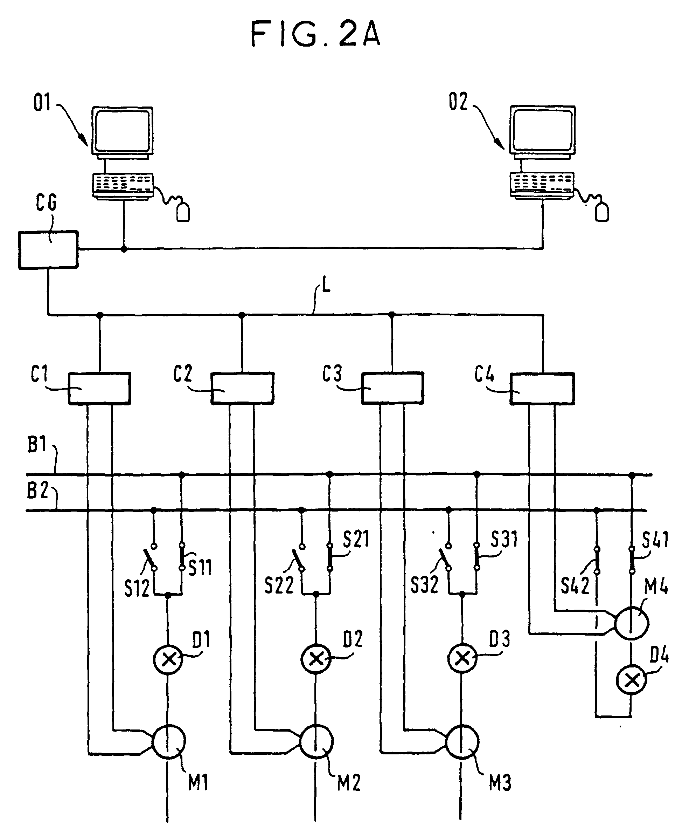

Sur les figures 2A à 2D, ce même poste haute tension est représenté avec ses équipements de contrôle.

Sur ces figures, les flèches représentent les transferts d'informations.

Chaque travée est équipée d'un calculateur de travée C1 à C4 pouvant déterminer entre autre la valeur et la polarité du courant passant dans la travée grâce à un dispositif de mesure du courant M1 à M4, ainsi que l'état (ouvert ou fermé) des sectionneurs de la travée.

Tous ces calculateurs C1 à C4 sont reliés par une ligne de transfert d'informations L et relié à un calculateur de niveau supérieur CG gérant lesdits calculateurs C1 à C4. Ce dernier calculateur CG est connecté à un poste opérateur O1 et selon l'invention avantageusement à un second poste opérateur O2 dont la fonction sera précisée plus loin.

La figure 2A représente le poste avant une opération de transfert en charge. Aucune mesure spécifique au procédé conforme à l'invention est faite et aucune information est transmise aux calculateurs C1 à C4.

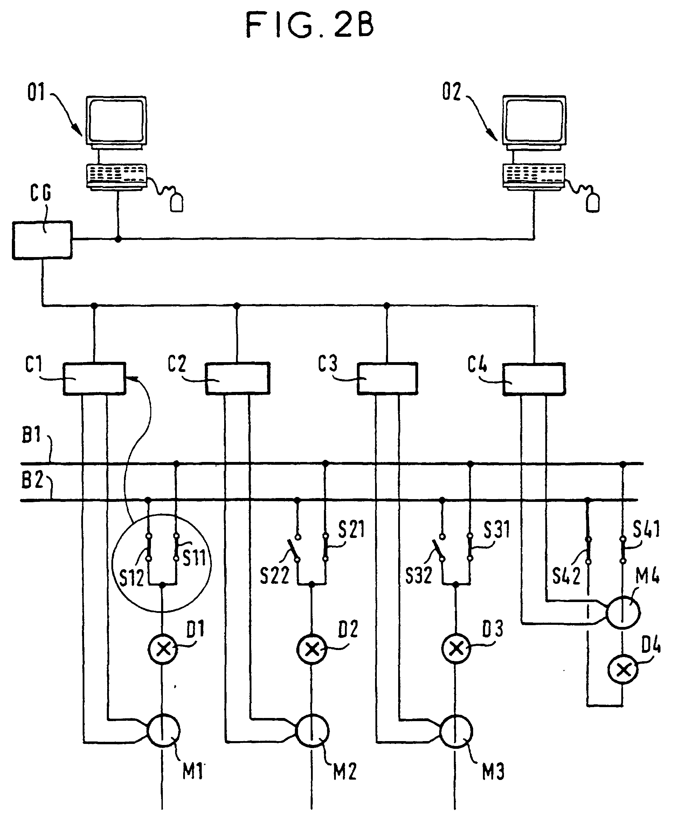

Sur la figure 2B, l'opération de transfert de charge est commencée et les deux sectionneurs d'aiguillage S11 et S12 sont fermés. Cet état est détecté et transmis au calculateur C1 de la travée T1.

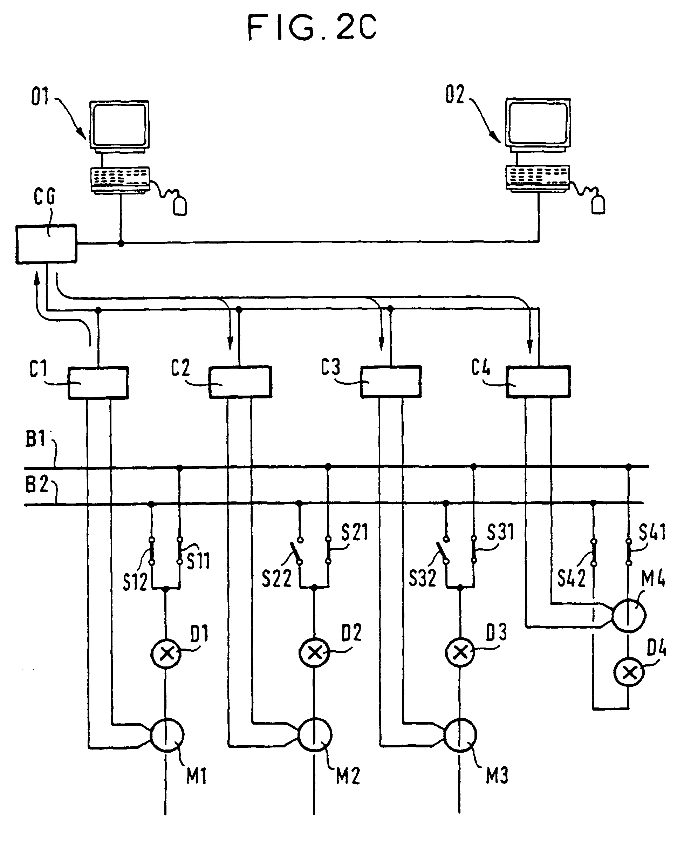

A ce moment, comme schématisé sur la figure 2C, le calculateur C1 envoie via le calculateur de niveau supérieur CG un message aux autres calculateurs C2 à C3 qui déterminent alors et enregistrent les données que sont la valeur et la polarité du courant de leur travée respective T2 à T3.

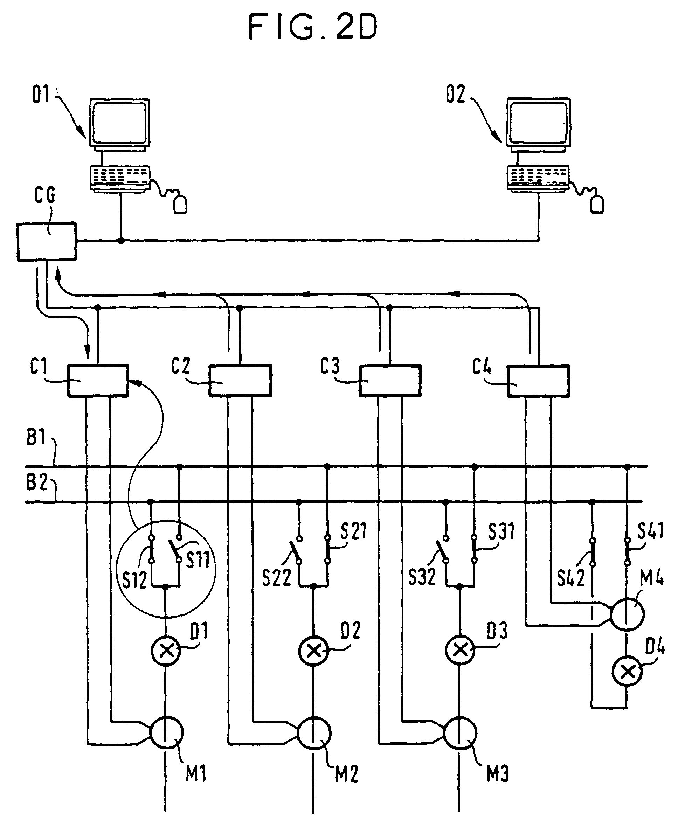

Lorsque le calculateur C1 a détecté l'ouverture du sectionneur d'aiguillage S11 de la ligne de connexion à la barre B1 dont la distribution est transférée, dite barre transférée, et donc la fin de l'opération de transfert en charge, comme représenté sur la figure 2D, lesdites données antérieures à l'ouverture (correspondantes à l'instant t juste avant l'ouverture) sont transmises des calculateurs C2 à C3 au calculateur CG.

Ce calculateur CG en déduit par calcul la valeur du courant coupé par le sectionneur S11 en ajoutant les valeurs de courant entrant sur la barre transférée B1 et en retranchant les valeurs de courant sortant de la barre transférée B1, ce calcul appliquant la loi de Kirshof des noeuds électriques. Par sa fonction de contrôle classique, le calculateur CG connaît la barre B1 ou B2 de distribution connectée à chaque travée (information équivalente à l'état (ouvert ou fermé) des sectionneurs d'aiguillage de chaque travée qui lui est transmise par les calculateurs C2 à C4).

Le calculateur CG calcule la valeur du carré du courant coupé par ledit sectionneur S11 représentative de l'usure électrique subie par le sectionneur S11 lors de cette opération de transfert en charge.

Cette valeur est transmise au calculateur C1 qui effectue la sommation de ces valeurs au fur et à mesure des différents transferts en charge et compare cette somme à une valeur limite admissible.

Le poste opérateur 02 peut permettre de visualiser de manière conviviale cette surveillance de l'usure électrique de chaque sectionneur d'aiguillage.

Le procédé conforme à l'invention peut être utilisé sans intervention d'un calculateur de niveau supérieur. Dans ce cas, ledit message du calculateur C1 est transmis directement aux autres calculateurs C2 à C3 et lesdites données sont transmises directement des calculateurs C2 à C3 au calculateur C1 qui effectue alors lui-même le calcul du carré du courant coupé par le sectionneur S11.

## Revendications

1. Procédé de surveillance de l'usure électrique des sectionneurs d'aiguillage (S11, S12) d'une travée (T1) d'un poste haute tension comportant un jeu de barres de distribution (B1, B2) relié à au moins trois circuits électriques constitués de travées d'entrée (T3) et de sortie (T1, T2) et d'une travée de couplage (T4) des barres (B1, B2), chaque travée (T1 à T4) comportant une ligne de connexion à chaque barre (B1, B2) équipée d'un sectionneur d'aiguillage et étant associée à un calculateur de travée (C1 à C4) pouvant déterminer la valeur et la polarité du courant passant dans la travée (T1 à T4), ainsi que l'état des sectionneurs d'aiguillage de la travée, tous les calculateurs (C1 à C4) du poste étant reliés par une ligne de transfert d'informations, **caractérisé en ce que**
- lors d'un transfert en charge de la travée (T1), lorsque le calculateur de travée (C1) correspondant détecte que les sectionneurs (S11, S12) des lignes de connexion aux barres de distribution (B1, B2) sont fermés, ce dernier envoie un message aux autres calculateurs (C2 à C4) qui déterminent et enregistrent les données que sont la valeur et la polarité du courant de leur travée (T2 à T4),
- lorsque le calculateur (C1) de la travée (T1) a détecté l'ouverture du sectionneur d'aiguillage (S11) de la ligne de connexion à la barre (B1) dont la distribution est transférée dite barre transférée, lesdites données antérieures à l'ouverture sont mémorisées et la valeur du carré du courant coupé par ledit sectionneur (S11) est calculée, cette valeur étant représentative de l'usure electrique dudit sectionneur.

2. Procédé selon la revendication 1, **caractérisé en ce que**
- ledit calculateur (C1) envoie ledit message aux autres calculateurs (C2 à C4) via un calculateur de niveau supérieur (CG),
- lesdites données sont transmises au calculateur de niveau supérieur (CG) qui en déduit par calcul la valeur du carré du courant coupé par ledit sectionneur (S11).

3. Procédé selon la revendication 1 ou 2, **caractérisé en ce que** le calculateur de niveau supérieur (CG) transmet la valeur du carré du courant coupé au calculateur (C1) de la travée (T1) qui effectue la sommation des valeurs au fur et à mesure des différents transferts en charge et compare cette somme à une valeur limite admissible.

4. Procédé selon la revendication 1 ou 2, **caractérisé en ce que** le calcul du courant coupé par ledit sectionneur (S11) s'effectue en ajoutant les valeurs de courant entrant sur la barre transférée (B1) et en retranchant les valeurs de courant sortant de la barre transférée (B1).

## Patentansprüche

1. Verfahren zur Überwachung des Verschleißes der Trennschalter (S11, S12) eines Feldes (T1) einer Hochspannungsstation, einen Satz Verteilungssammelschienen (B1, B2) umfassend, verbunden mit wenigstens drei Stromkreisen, gebildet durch ein Einspeisungsfeld (T3) und Ausspeisungsfelder (T1, T2) und ein Kopplungsfeld (T4) der Sammelschienen (B1, B2), wobei jedes Feld (T1 bis T4) eine Verbindungsleitung zu jeder Schiene (B1, B2) umfasst, ausgerüstet mit einem Trennschalter und einem Feldrechner (C1 bis C4) zugeordnet, der den Wert und die Polarität des in dem Feld (T1 bis T4) fließenden Stroms sowie den Zustand der Trennschalter des Felds bestimmen kann, wobei alle Rechner (C1 bis C4) der Station durch eine Datenübertragungsleitung verbunden sind,
**dadurch gekennzeichnet,**
- **dass** bei einer Lastübertragung des Felds (T1), wenn der entsprechende Feldrechner (C1) detektiert, dass die Trennschalter (S11, S12) der Verbindungsleitungen zu den Verteilungssammelschienen (B1, B2) geschlossen sind, dieser den anderen Rechnern (C2 bis C4) eine Mitteilung sendet, welche die Daten bestimmen und abspeichem, die der Wert und die Polarität des Stroms ihres Feldes (T2 bis T4) sind,
- **dass** - wenn der Rechner (C1) des Feldes (T1) die Öffnung des Trennschalters (S11) der Verbindungsleitung zu der Sammelschiene (B1), deren Verteilung übertragen wird, Übertragungssammelschiene genannt, detektiert hat -, die genannten, der Öffnung vorausgehenden Daten abgespeichert werden und der Wert des Quadrats des durch den genannten Trennschalter (S11) unterbrochenen Stroms berechnet wird, wobei dieser Wert repräsentativ ist für den elektrischen Verschleiß des genannten Trennschalters.

2. Verfahren nach Anspruch 1, **dadurch gekennzeichnet:**
- **dass** der genannte Rechner (C1) die genannte Mitteilung an die anderen Rechner (C2 bis C4) über einen Rechner höheren Niveaus (CG) sendet,
- **dass** die genannten Daten an den Rechner höheren Niveaus (CG) übertragen werden, der daraus durch Berechnung den Wert des Quadrats des durch den genannten Trennschalter (S11) unterbrochenen Stroms berechnet.

3. Verfahren nach Anspruch 1 oder 2, **dadurch gekennzeichnet, dass** der Rechner höheren Niveaus (CG) den Wert des Quadrats des unterbrochenen Strom an den Rechner (C1) des Feldes (T1) sendet, der nach und nach die Werte der verschiedenen Lastübertragungen summiert und die errechnete Summe mit einem zulässigen Grenzwert vergleicht.

4. Verfahren nach Anspruch 1 oder 2, **dadurch gekennzeichnet, dass** die Berechnung des durch den genannten Trennschalter (S11) unterbrochenen Stroms erfolgt, indem man die Eingangsstromwerte der Übertragungssammelschiene (B1) hinzufügt und die Ausgangsstromwerte der Übertragungssammelschiene (B1) abzieht.

## Claims

1. Method of monitoring the electrical wear of selector switch disconnectors (S11, S12) in a bay (T1) of a high voltage station that includes a set of distribution busbars (B1, B2) connected to at least three electrical circuits constituted by an inlet bay (T3), an outlet bay (T1, T2), and a coupling bay (T4) for coupling together the busbars (B1, B2), each bay (T1 to T4) including a respective connection line to each busbar (B1, B2) fitted with a respective selector switch disconnector, and being associated with a bay computer (C1 to C4) capable of determining the magnitude and the polarity of the current flowing through the bay (T1 to T4), and also the states of the selector switch disconnectors in the bay, with all of the computers (C1 to C4) of the station being interconnected by an information transfer line, **characterized in that**
. when a bay (T1) is being transferred under load, once the corresponding bay computer (C1) detects that the disconnectors of the lines for connection to the distribution busbars (B1, B2) are all closed, it sends a message to the other computers (C2 to C4) which then determine and record data comprising the magnitude and the polarity of the current flowing through the corresponding bays (T2 to T4); and
. when the computer (C1) of the bay (T1) being transferred detects opening of the selector switch disconnector (S11) of the line for connection to the busbars (B1) whose distribution is being transferred, referred to as the "transferred" busbar, said data prior to opening is stored and the value of the square of the current interrupted by said disconnector (S11) is computed, said value being representative of the electrical wear of said disconnector.

2. Method according to claim 1, **characterized in that**:
· said computer (C1) sends said message to the other computers (C2 to C4) via a higher level computer (CG);
· said data is transmitted to the higher level computer (CG) which deduces therefrom, by calculation, the value of the square of the current interrupted by said disconnectors (S11).

3. Method according to claim 1 or 2, **characterized in that** the higher level computer (CG) transmits the value of the square of the current interrupted to the computer (C1) of the bay (T1), which computer sums said values each time a transfer operation is performed under load and compares the sum with an acceptable limit value.

4. Method according to claim 1 or 2, **characterized in that** the current interrupted by said disconnector (S11) is computed by adding together the currents entering the transferred busbar (B1) and by subtracting therefrom the currents leaving the transferred busbar (B1).
